# EUROPEAN PATENT SPECIFICATION

(11) **EP 1 565 931 B1**
(45) Date of publication and mention of the grant of the patent: **07.11.2007**
(21) Application number: 02791319.3
(22) Date of filing: 25.11.2002
(51) Int. Cl.: H01L 21/00

(54) **STRAINED FINFET CMOS DEVICE STRUCTURES**
VERSPANNTE CMOS FINFET BAUELEMENTESTRUKTUREN
STRUCTURES DE DISPOSITIF CMOS FINFET CONTRAINT

(43) Date of publication of application: 24.08.2005
(73) Proprietor: International Business Machines Corporation, Armonk, NY 10504 (US)
(72) Inventor: DORIS, Bruce, B. c/o IBM United Kingdom Limited, Hampshire SO21 2JN (GB); CHIDAMBARRAO, Dureseti, Weston, CT 06883 (US); IEONG, Meikei, Wappingers Falls, NY 12590 (US); MANDELMAN, Jack, A., Flat Rock, NC 28731 (US)
(74) Representative: Litherland, David Peter
(86) International application number: PCT/US2002/037931
(87) International publication number: WO 2004/049406

(56) References cited:
- US-A1- 2002 093 046
- US-A1- 2003 040 158
- US-B1- 6 342 410
- US-B1- 6 413 802
- US-B1- 6 433 609
- US-B1- 6 458 662
- US-B1- 6 573 172
- SHIMIZU A ET AL: "Local mechanical-stress control (LMC) a new technique for CMOS-performance enhancement" INTERNATIONAL ELECTRON DEVICES MEETING 2001. IEDM. TECHNICAL DIGEST. WASHINGTON, DC, DEC. 2 - 5, 2001, NEW YORK, NY : IEEE, US, 2 December 2001 (2001-12-02), pages 1941-1944, XP010575160 ISBN: 0-7803-7050-3
- ITO S ET AL: "Effect of mechanical stress induced by etch-stop nitride: impact on deep-submicron transistor performance" MICROELECTRONICS AND RELIABILITY, ELSEVIER SCIENCE LTD, GB, vol. 42, no. 2, February 2002 (2002-02), pages 201-209, XP002332483 ISSN: 0026-2714
- ITO S ET AL: "Mechanical stress effect of etch-stop nitride and its impact on deep submicron transistor design" ELECTRON DEVICES MEETING, 2000. IEDM TECHNICAL DIGEST. INTERNATIONAL DECEMBER 10-13, 2000, PISCATAWAY, NJ, USA,IEEE, 10 December 2000 (2000-12-10), pages 247-251, XP010531755 ISBN: 0-7803-6438-4

## Description

### Technical Field

The present invention relates to a method of manufacturing double gate semiconductor device structures and, more particularly, FinFET devices.

### Background Art

Double gate semiconductor device structures are promising candidates for future generation microelectronics devices, because of the ability to obtain near ideal sub-threshold slope, absence of body-effect, immunity to short-channel effect, and very high current driveability. One double gate device structure of technological relevance is the FinFET. The FinFET is particularly attractive because of the relative simplicity of manufacture compared to other double gate devices. The channel for the FinFET is a thin rectangular island of Si, commonly referred to as the Fin. The gate wraps around the Fin so that the channel is gated on both sides of the vertical portions of the Fin structure, providing gate control which is superior to planar single gate MOSFETs.

FinFETs are well known. See, for example, U.S. Patent No. 6,413,802, entitled "FinFET Transistor Structures Having a Double Gate Channel Extending Vertically from a Substrate and Methods of Manufacture" by Hu et al., filed October 23, 2000, issued July 2, 2002, which is hereby incorporated in its entirety by reference. FinFETs having enhanced mobility are also known. See, for example, U.S. Patent Application No.. 2002/0063292 A1, entitled "CMOS Fabrication Process Utilizing Special Transistor Orientation" by Armstrong et al., filed November 29, 2000, published May 30, 2002, which is hereby incorporated in its entirety by reference. This prior art method is directed at improving nFET mobility and, therefor, only limited improvement in CMOS circuits can be attained. Thus, a need exists for a method to improve mobility for p-FinFETs and n-FinFETs which are situated on the same wafer.

"Local Mechanical Stress Control (LMC): A new Technique for CMOS-Performance Enhancement" by A. Shimizu et al., IEDM 2001, discloses a method of inducing strain in complementary planar MOSFET.

However, the present inventors believe that improvements in utilizing stressing layers to enhance mobility are achievable.

### Disclosure of Invention

This invention is directed to a novel strained FinFET device manufacturing process for enhanced mobility. The integration scheme incorporates a new process flow that induces compressive stress in the longitudinal direction for the p-FinFET while also inducing tensile stress in the longitudinal direction for the n-FinFET. These stresses significantly enhance mobility and, thus, enhance device performance. In the invention described herein, the longitudinal stress induced in the channel is enhanced considerably from what can be obtained in standard planar MOSFETs, because the stressing film is applied from two sides of a thin FinFET, instead of on the surface of an SOI layer or bulk substrate.

It is a principal object of the present invention to enhance mobility in double gate CMOS device structures.

It is an additional object of the present invention to enhance mobility in FinFET device structures.

It is a further object of the present invention to improve methods of fabricating strained FinFET device structures.

The invention and other objects and features thereof will be more readily apparent from the following detailed description when taken in conjunction with the following drawing figures.

### Brief Description of Drawings

Figures 1 and 2 schematically show perpendicular (to Fin) and parallel (to Fin) views of a FinFET according to the prior art.
Figure 3 schematically shows a perpendicular view of a FinFET semiconductor device structure according to the prior art.
Figures 4 - 17 schematically show various views of intermediate and final FinFET semiconductor device structures according to the present invention.

### Best Mode for Carrying Out the Invention

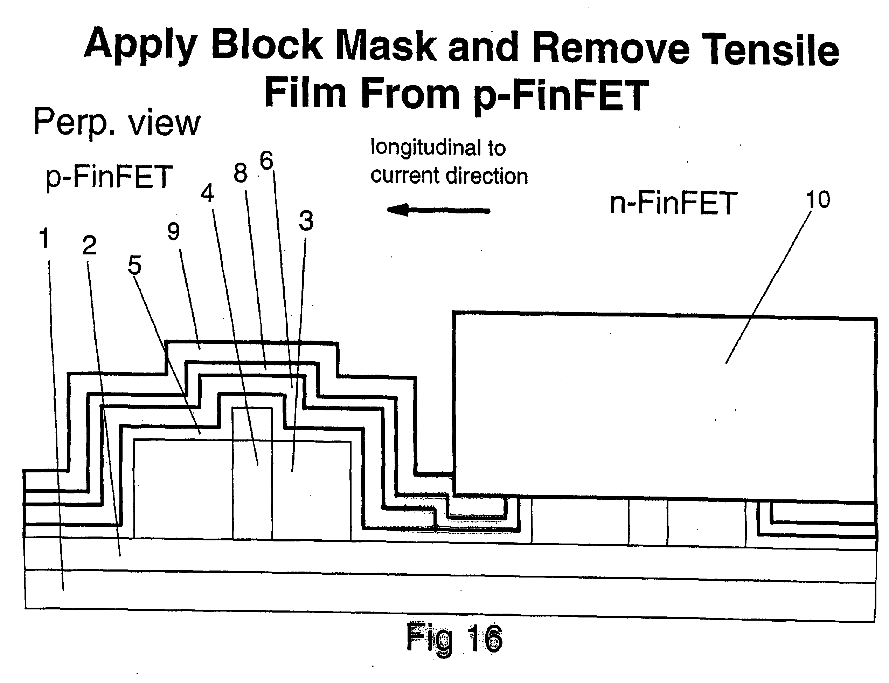

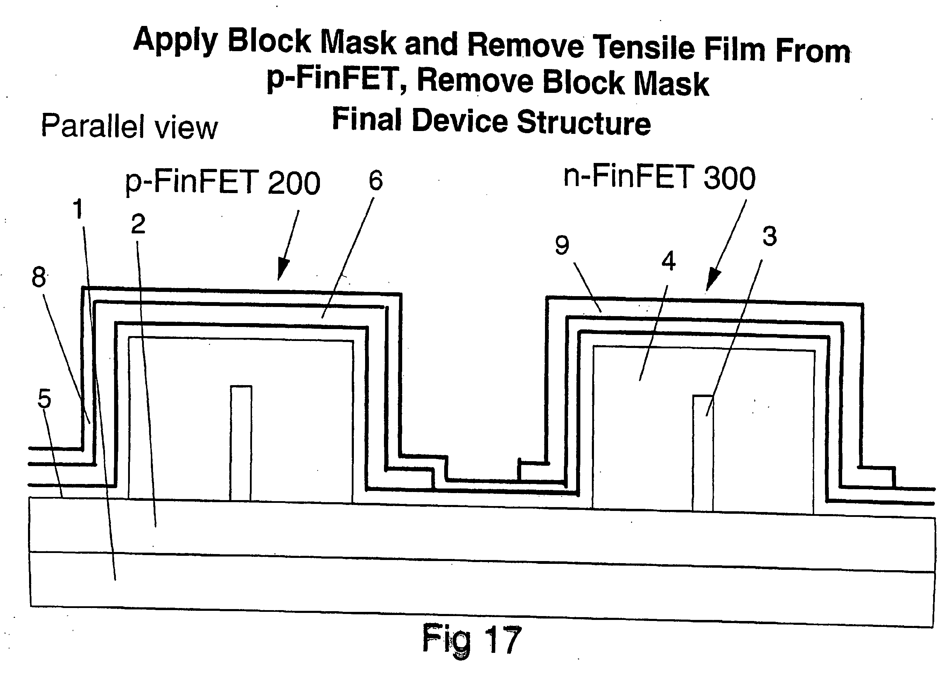

The present invention is directed to a novel FinFET semiconductor device structure and a method of manufacturing such structure. A preferred final structure according to the present invention is shown in Figures 16, 17.

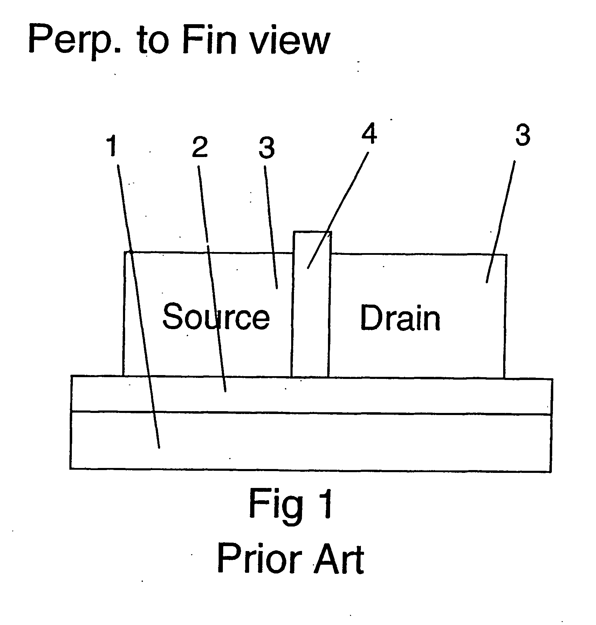

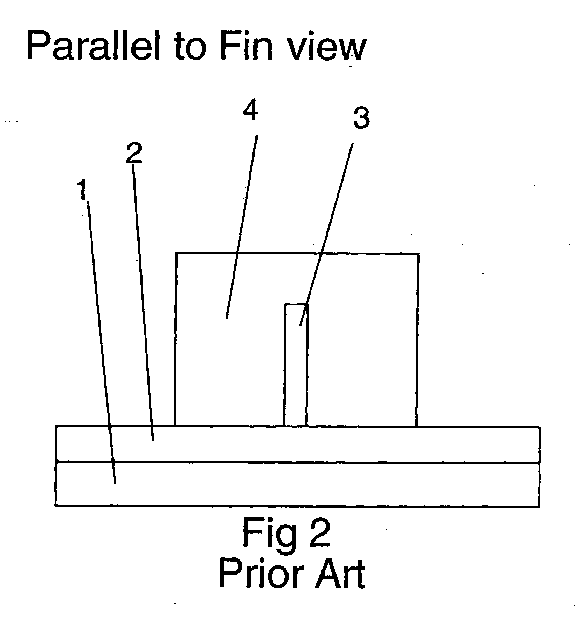

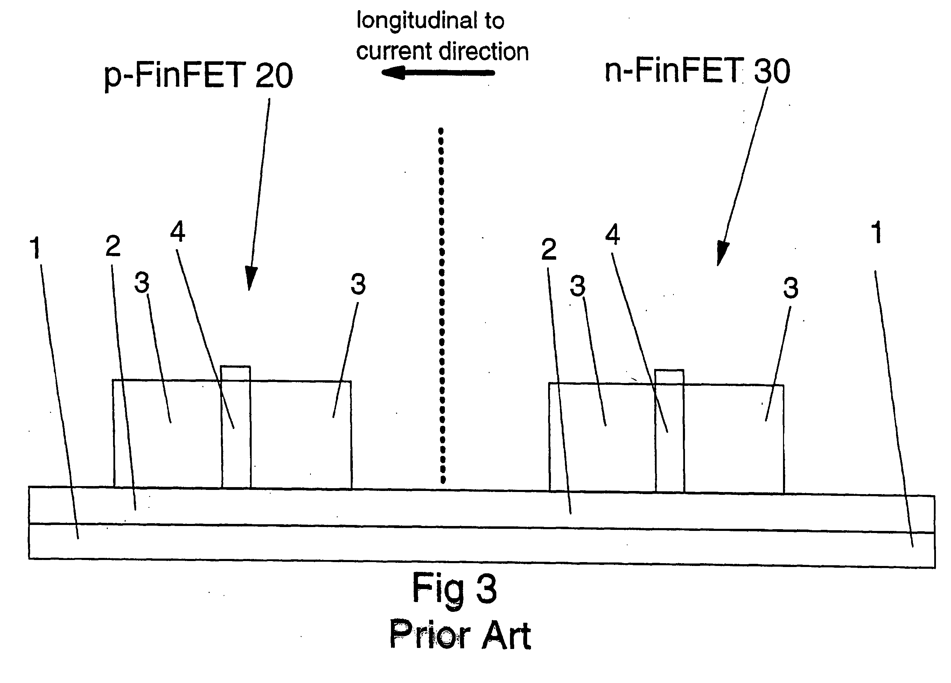

Referring now to the remaining figures and Figures 1 - 3 in particular, there are shown known FinFET devices (Figs. 1, 2) and device structures (Fig. 3).

To begin, standard or conventional FinFET device manufacture processing is followed through the patterning and etching of the Fins, formation of gate dielectric and conductors, sidewall spacers (not shown), source/drain doping, and salicidation. Following salicidation, the gate sidewall spacers are removed, to facilitate the processing which will induce strain in the Fins according to the present invention.

More particularly, as described with reference to Fig. 3, an SOI wafer, for example, is provided. The SOI wafer includes a substrate **1**, disposed underneath a buried SiO₂ layer 2 as shown in Fig. 3. On top of the buried SiO₂ layer **2**, is a Silicon on Insulator (SOI) layer which is patterned into regions forming the active area of each device shown as a FIN **3** in Figs. 1, 2 and 3. The Fin may be formed by standard lithography and etching operations well known in the art. Alternatively, a known side wall image transfer method may be used to form each Fin **3**.

After the Fin has been formed, a sacrificial oxidation procedure which is well known in the art may be performed to remove any damage from the Fin etch procedure. The sacrificial oxide layer can be used as a screen to prevent channeling during well implantation, if well implantation is used to adjust the threshold voltage of the FinFET device.

The sacrificial oxide is next removed by a dry or wet etch chemistry. For example, a dilute hydrofluoric acid may be used to remove the sacrificial oxide. After the sacrificial oxide removal, a gate dielectric may be formed. The gate oxidation may be a thermal SiO₂, a nitrided SiO₂ or oxy nitride. The gate dielectric may be a high K material like TaO₅, HfO₂, or any other gate dielectric material.

The gate electrode material is next deposited on the entire wafer, after which a lithography and etching procedure may be carried out. The gate electrode is labeled electrode **4** in the diagram.

After gate formation, a reoxidation operation, which is well known in the art, may be used to improve gate dielectric characteristics. The gate re-ox may also be omitted.

At this point in the process flow, the source/drain extensions may be implanted, in another approach, an offset spacer may be used to create a distance between the gate edge and the implanted Fin region. A lithography mask may be used to block nFET regions from being implanted while allowing the pFET regions to be implanted as is common to conventional CMOS process technology. A similar operation can be used to implant the nFET regions while blocking the pFET regions.

After the source drain extension regions have been formed, an extension anneal may be used to heal the damage created by the ion implantation. In an alternate approach, the anneal may be omitted. Next, the deep source drain spacers are fabricated by depositing a SiN film in the range of 100Å to 1000Å, after which a highly directional etch is performed to remove the SiN film from the horizontal surfaces while leaving the film on the vertical portions of the gate electrode.

A block mask and ion implantation are now used to form the source and drain regions for the nFET device region **30** and pFET device region **20** as is standard in CMOS process technology. A conventional rapid thermal annealing process is next used to activate the junctions formed by the implantation. After this, a conventional salicide process using CoSi₂, TiSi, NiSi or any other silicide known in the art is performed.

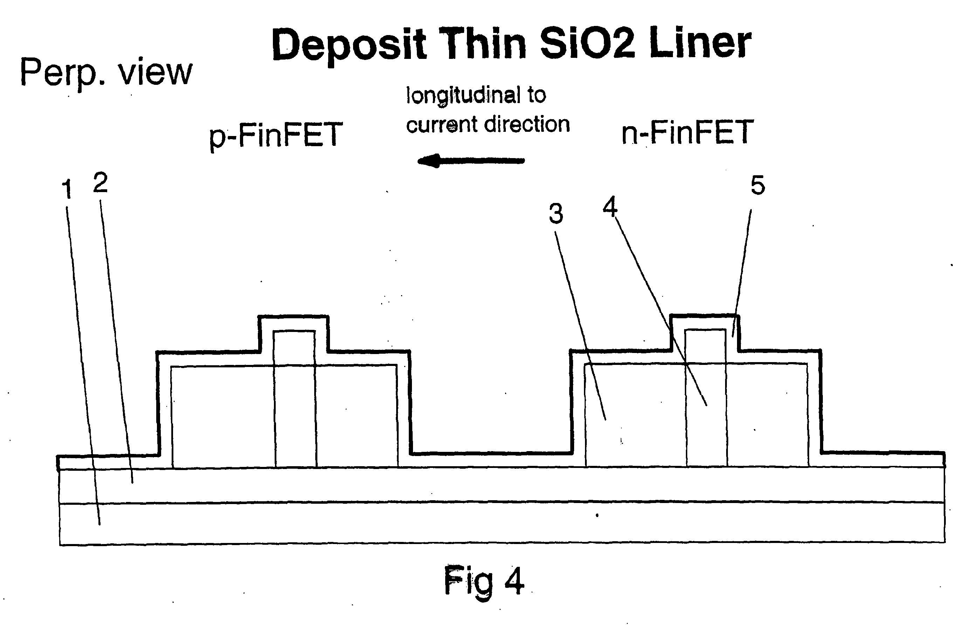

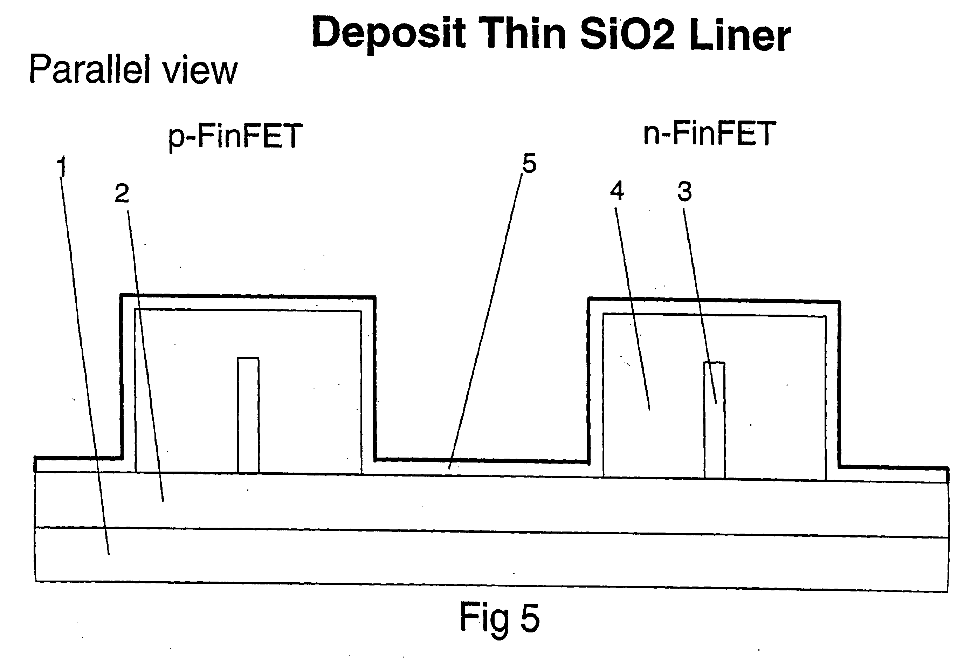

At this point in the process flow, the inventive steps and structures (Figs. 4-17) to improve device performance for the n-FinFET and p-FinFET devices begin. First, as shown in Fig. 4 and Fig. 5, an SiO₂ liner layer (film) 5 is disposed (e.g., deposited) by, e.g., a low temperature deposition technique. The film thickness is in the range of 25-300Å and the film deposition temperature is in the range of200-750°C. The film may be deposited by any one of a variety of different known techniques including, but not limited to, sputter deposition, Plasma Enhanced Chemical Vapor Deposition (PECVD), Rapid Thermal Chemical Vapor Deposition (RTCVD), or a standard Chemical Vapor Deposition (CVD) technique. The purpose of this SiO₂ film **5** is to act as an etch stop for a second film which is to be deposited next. Thus, the liner or etchstop layer **5** need not be SiO₂, but is any material that can provide adequate etch stop capability for the next film that is deposited directly on top of the liner material layer **5**.

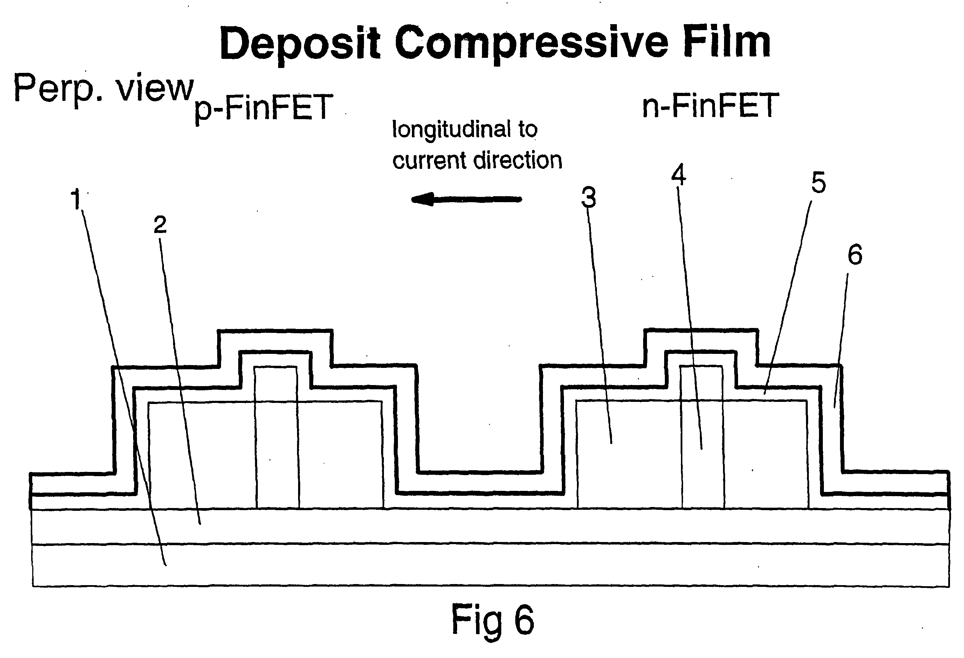

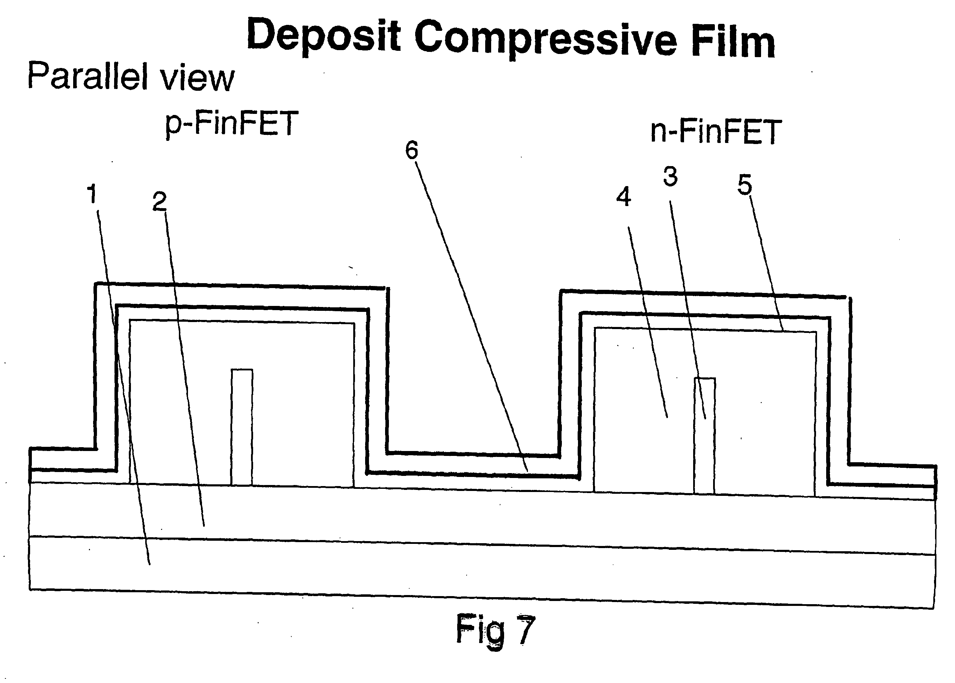

After deposition of the liner or etch stop layer **5**, a compressive film **6**, as shown in Fig. 6 and Fig. 7, is deposited over the entire wafer. In a preferred embodiment, the compressive film **6** is a SiN film deposited, e.g., by PECVD. The film **6** may also be deposited at an elevated power, in the range 400W to 1500W, to create more compression in the film. The film may be deposited using a low deposition rate and temperature range to make the film compressive. Ideally, the compression in the film is in the range of -300MPa to -3000MPa and the film thickness should be in the range of 200Å to 2000Å. Preferred deposition parameters are as follows: process temperature of 480°C, pressure of 5.75 torr, spacing between wafer and electrode of 395 mils, flow 3000 seem of a 2% diluted SiH₄ gas, 15 seem NH₃ gas and 1060 sccm N gas using an RF power of 900 Watts. This process yields a deposition rate of approximately 15.95Å/s and a film stress of about (±10%) -1400 MPa.

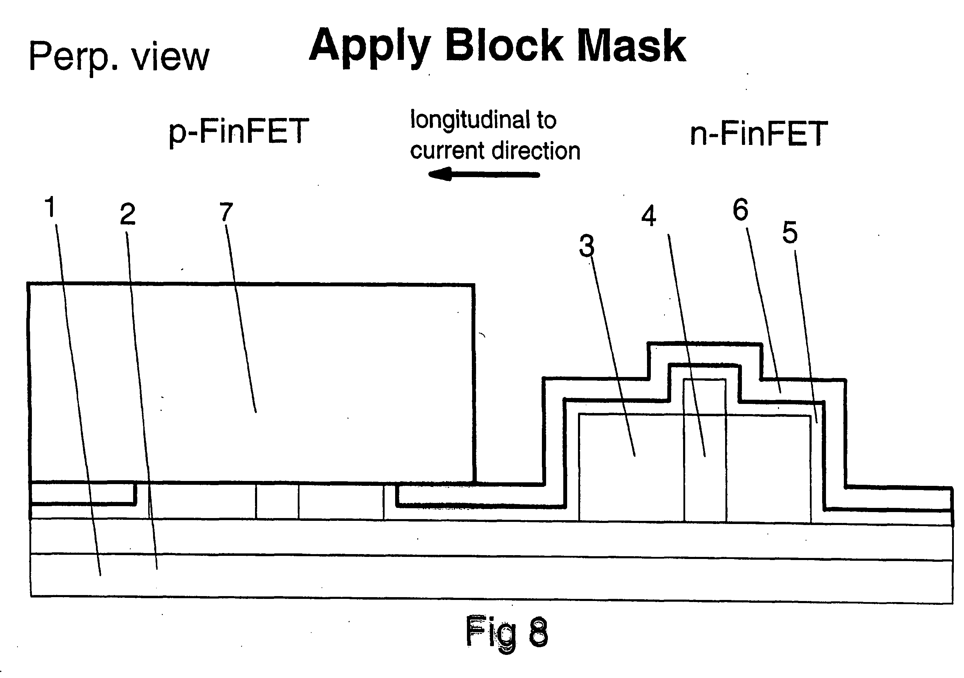

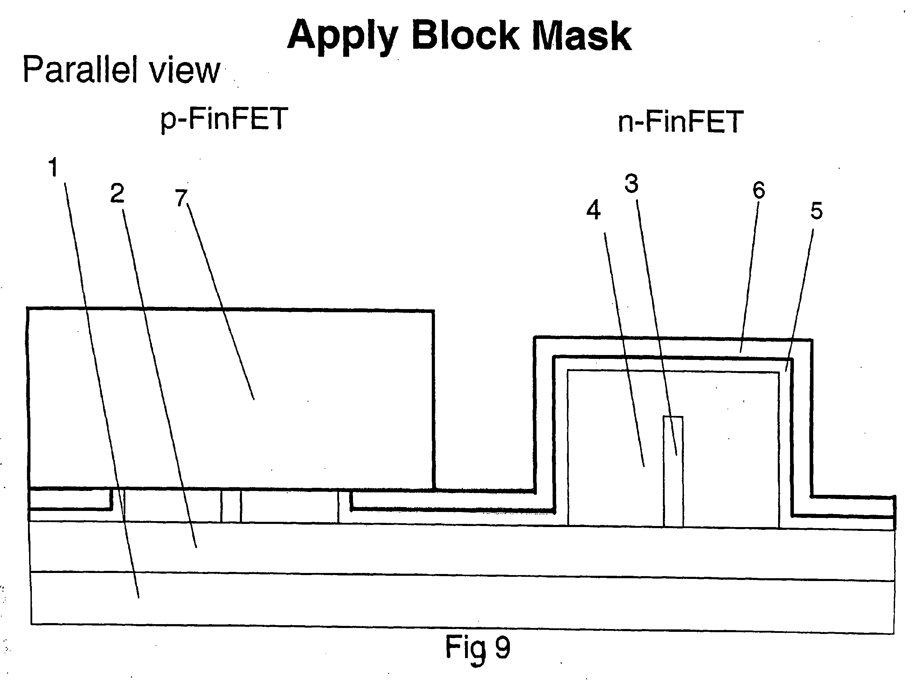

After the compressive film 6 has been applied to the wafer, a block mask **7**, as shown in Fig. 8 and Fig. 9, is used to mask to pFET regions of the wafer. This block mask may be formed by conventional lithographic techniques known in the art. The mask is formed by a conventional lithography procedure in which a photosensitive material is coated over the wafer surface and exposed through a mask. The photosensitive material is then developed, leaving resist images or features blocking the pFET areas on the wafer.

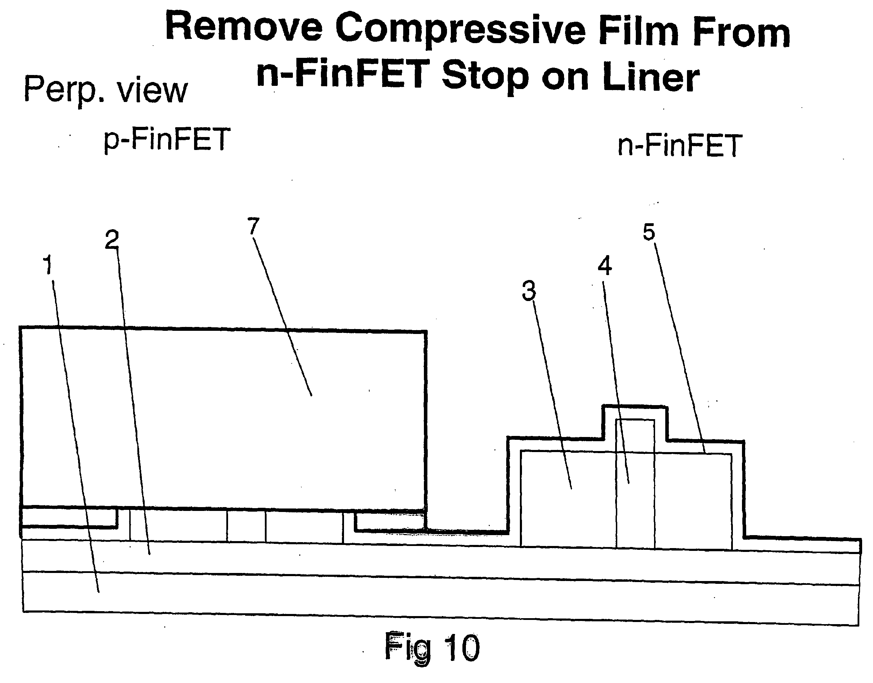

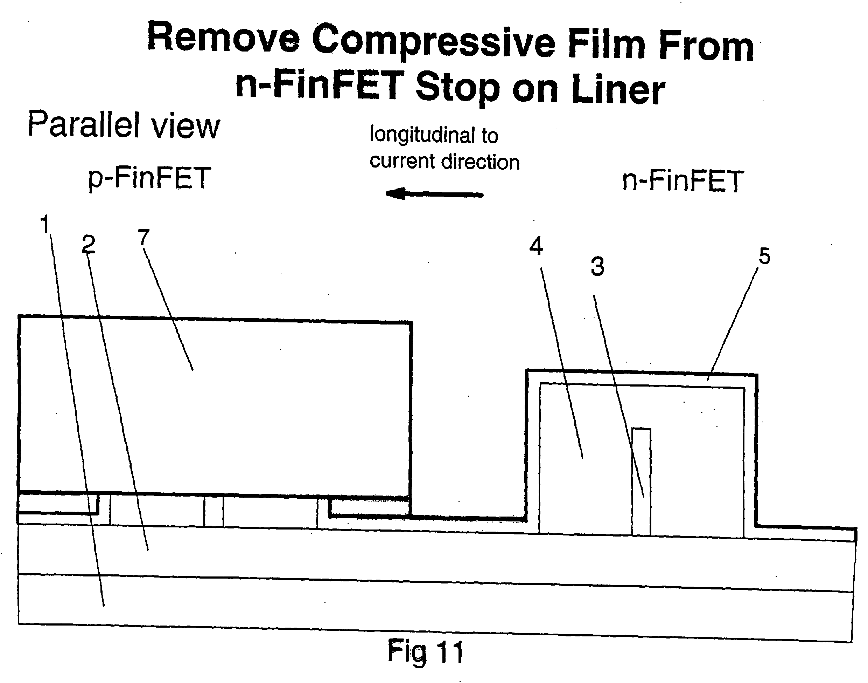

After formation of the block mask 7, the compressive film **6** is removed by a known wet etching or dry etching technique that is capable of removing the compressive film selectively with respect to the block mask material. A plasma consisting of CH₂F₂ is an example of a dry etch chemistry that may be used for this purpose if the compressive film is SiN. After the compressive film has been removed from the nFET regions on the wafer, an intermediate structure appears as shown in Fig. 10 and Fig. 11.

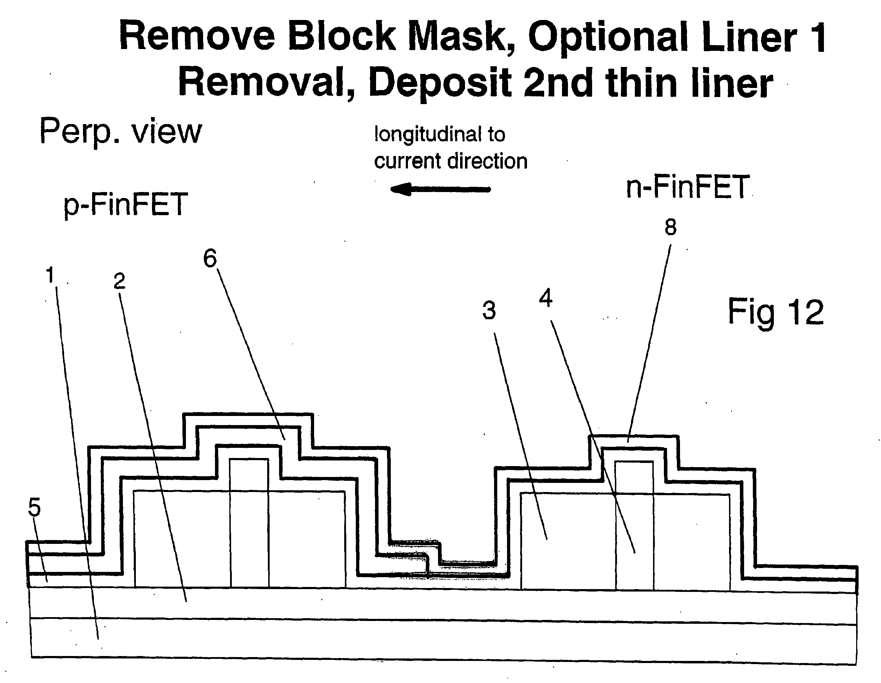

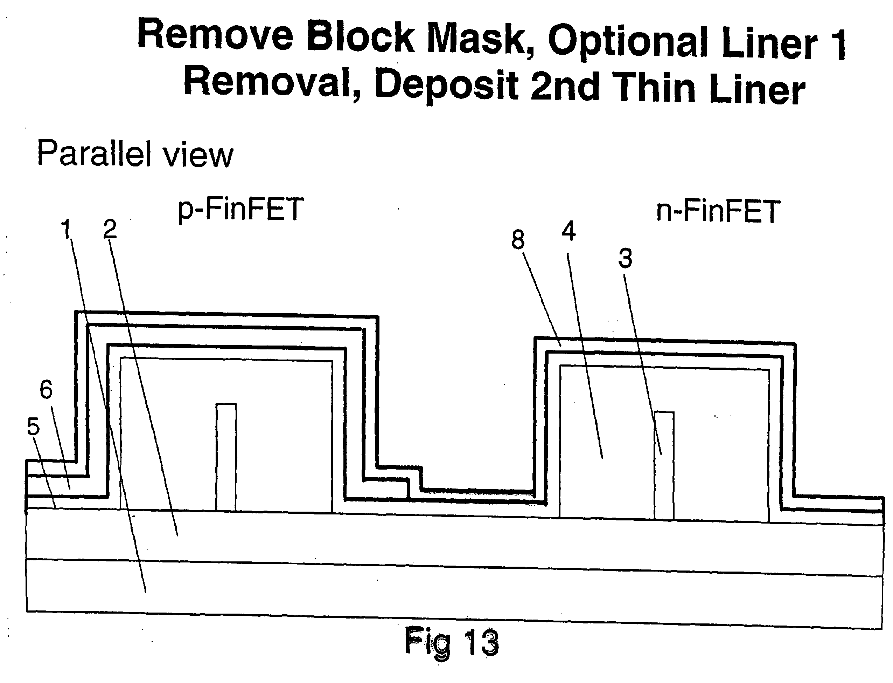

At this point in the inventive process flow, the block mask **7** is removed from the wafer using a solvent or O₂ plasma process known in the art to remove resist or organic materials. Next, a second liner or etchstop material **8** is deposited on the entire wafer as shown in Figs. 12 and 13. The second liner layer **8** has at least similar properties as the first liner previously described. That is, the liner is to be used as an etch stop for a subsequent film etching process.

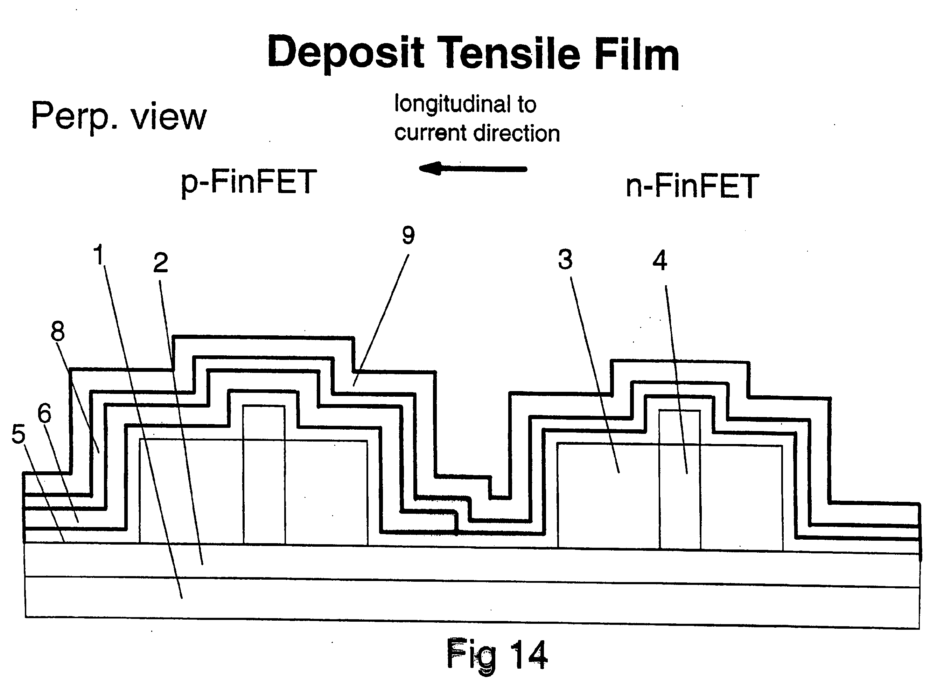

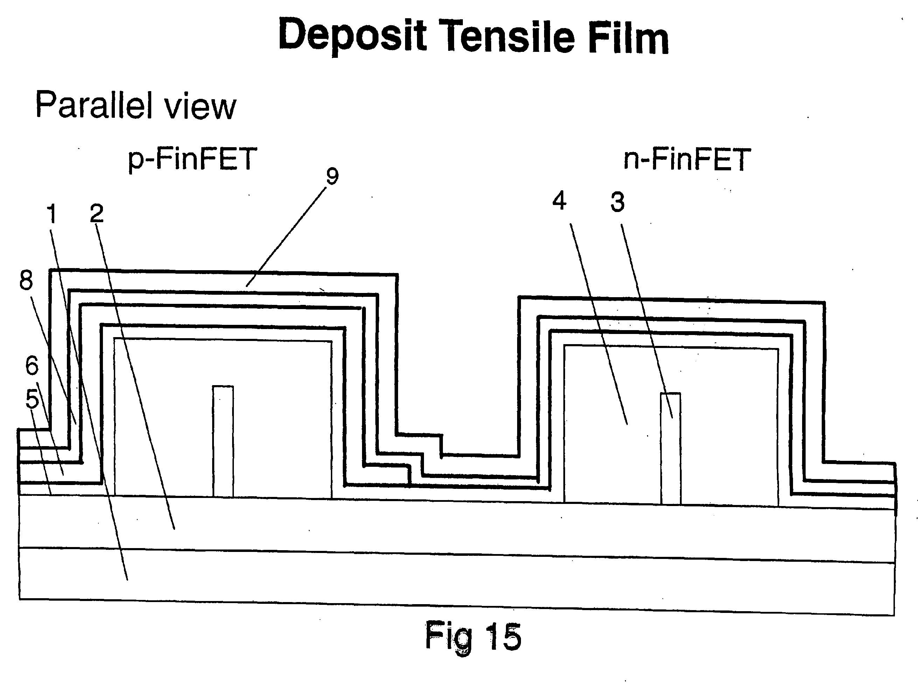

Next, a tensile film **9** is deposited over the entire wafer as shown in Fig. 14 and Fig. 15. The tensile film is, e.g., SiN and is deposited by, e.g., CVD, PECVD, RTCVD or any other deposition technique capable of depositing a highly tensile film. The film thickness should be in the range of 200Å to 2000Å, and the stress should be in the range +200MPa to +2000MPa or more tensile. Preferred deposition parameters are:
process temperature of 480°C, pressure of 6.25 torr, spacing between wafer and electrode of 490 mils, flow 3000 sccm of a 2% dilute SiH₄ gas, 15 sccm NH₃ gas and 1060 sccm N gas using an RF power of 340 Watts. This process yields a deposition rate of approximately 23Å/s and a film stress of about 500 MPa.

At this point in the inventive process flow, a block mask **10** is patterned over the nFET regions of the wafer as shown in Fig. 16. The properties of this block mask are similar to the properties of the block mask previously described to block the pFET regions. After the block mask has been defined, a known wet or dry etching procedure is carried out to remove the tensile film **9** from the pFET regions. The etch should be selective to the liner etch stop material **8**. In this way, the etch used to remove the tensile film from the nFET regions does not remove the compressive film which is present on the pFET regions. The block mask is next removed using a similar methodology used to remove the first block mask, to result in the final device structure **200, 300** shown in Fig. 17.

At this point in the inventive process flow, a thin film (not shown) in the range of 50Å to 500Å, with a low stress in the range of -100 MPa compressive to +100 MPa tensile may be applied to the wafer to serve as a barrier layer. The purpose of this thin film is to fill in any regions not covered by the compressive or tensile films. This optional film may be used to improve the suppression of contamination from penetrating into the Si and also help to improve the etch stop characteristics for the source-drain contact etch.

After the operations described above are carried out, the CMOS process may be continued using standard process methodologies (not shown) well known in the art. More specifically, the processing that follows includes: deposition and planarization of a glass layer (i.e., BPSG, TEOS); etching of source/drain contacts, deposition of contact metallurgy and planarization; additional levels of insulating layers, vias, and wiring are then formed to complete the chip.

The presence of the stressed films on the longitudinal sidewalls of the Fins, overlying the gate conductors, results in a stress in the channel which is of the same type as the stress in the film (i.e., compressive/compressive, tensile/tensile). The stress in the source/drain regions on the longitudinal sidewalls of the Fins is of opposite type (i.e., compressive/tensile, tensile/compressive). To access the source/drain diffusions, the films on the top surface of each Fin may be removed without negating the effects of the film on the longitudinal sidewalls.

While there has been shown and described what is at present considered a preferred embodiment of the present invention, it will be apparent to those skilled in the art that various changes and modifications may be made therein without departing from the scope of the present invention as defined by the appended claims.

### Industrial Applicability

The present invention is applicable to microelectronic semiconductor devices.

## Claims

1. A method for manufacturing a semiconductor device structure, comprising:
providing a p-FinFET device region (20) and an n-FinFET device region (30) on a same substrate (1,2);
disposing a first liner (5) on the p-FinFET device region and the n-FinFET device region;
disposing a compressive film (6) on the first liner, so as to overlay the longitudinal side walls of the fin of the p-FinFET;
disposing a first mask (7) on the p-FinFET device region;
removing the compressive film from the n-FinFET device region;
removing the first mask (7);
disposing a second liner (8) on the p-FinFET device region and the n-FinFET device region;
disposing a tensile film (9) on the second liner, so as to overlay the longitudinal side walls of the fin of the n-FinFET;
disposing a second mask (10) on the n-FinFET device region;
removing the tensile film from the p-FinFET device region; and
then removing the second mask;
wherein the compressive film and the tensile film are respectively deposited as to induce compressive and tensile stress in the longitudinal direction of the respective FinFETs.

2. The method as claimed in claim 1, wherein said step of disposing a compressive film includes depositing a compressive film having a film stress of about -1400 MPa.

3. The method as claimed in claim 1, wherein said step of disposing a tensile film includes depositing a tensile film having a film stress of about +500 MPa.

4. The method as claimed in claim 1, wherein the compressive film is SiN.

5. The method as claimed in claim 1, wherein the tensile film is SiN.

6. The method as claimed in claim 1, wherein the compressive film is disposed having a substantially uniform thickness in a range of 200Å to 2000Å.

7. The method as claimed in claim 1, wherein the tensile film is disposed having a substantially uniform thickness in a range of 200Å to 2000Å.

8. The method as claimed in claim 1, wherein said step of disposing a compressive film includes depositing a compressive film having a film stress of greater than about -1400 MPa.

9. The method as claimed in claim 1, wherein said step of disposing a tensile film includes depositing a tensile film having a film stress of greater than about +500 MPa.

## Patentansprüche

1. Verfahren zur Herstellung einer Halbleitereinheitsstruktur, welches das Folgende umfasst:
Bereitstellen einer Zone einer p-FinFET-Einheit (20) und einer Zone einer n-FinFET-Einheit (30) auf demselben Substrat (1, 2);
Anordnen einer ersten Decklage (5) auf der Zone der p-FinFET-Einheit und der Zone der n-FinFET-Einheit;
Anordnen einer Druckdünnschicht (6) auf der ersten Decklage, derart, dass die longitudinalen Seitenwände der Finne des p-FinFET überzogen werden;
Anordnen einer ersten Maske (7) auf der Zone der p-FinFET-Einheit;
Entfernen der Druckdünnschicht von der Zone der n-FinFET-Einheit;
Entfernen der ersten Maske (7);
Anordnen einer zweiten Decklage (8) auf der Zone der p-FinFET-Einheit und der Zone der n-FinFET-Einheit;
Anordnen einer Zugdünnschicht (9) auf der zweiten Decklage, derart, dass die longitudinalen Seitenwände der Finne des n-FinFET überzogen werden;
Anordnen einer zweiten Maske (10) auf der Zone der n-FinFET-Einheit;
Entfernen der Zugdünnschicht von der Zone der p-FinFET-Einheit; und dann
Entfernen der zweiten Maske;
wobei die Druckdünnschicht und die Zugdünnschicht entsprechend derart angeordnet sind, dass eine Druck- und Zugspannung in der Längsrichtung der entsprechenden FinFETs erzeugt werden.

2. Verfahren nach Anspruch 1, wobei der Schritt des Anordnens einer Druckdünnschicht das Aufbringen einer Druckdünnschicht umfasst, welche eine Dünnschichtspannung von ungefähr -1400 MPa aufweist.

3. Verfahren nach Anspruch 1, wobei der Schritt des Anordnens einer Zugdünnschicht das Aufbringen einer Zugdünnschicht umfasst, welche eine Dünnschichtspannung von ungefähr +500 MPa aufweist.

4. Verfahren nach Anspruch 1, wobei es sich bei der Druckdünnschicht um SiN handelt.

5. Verfahren nach Anspruch 1, wobei es sich bei der Zugdünnschicht um SiN handelt.

6. Verfahren nach Anspruch 1, wobei die Druckdünnschicht derart angeordnet wird, dass sie eine im Wesentlichen einheitliche Dicke im Bereich von 200 Å bis 2000 Å aufweist.

7. Verfahren nach Anspruch 1, wobei die Zugdünnschicht derart angeordnet wird, dass sie eine im Wesentlichen einheitliche Dicke im Bereich von 200 Å bis 2000 Å aufweist.

8. Verfahren nach Anspruch 1, wobei der Schritt des Anordnens einer Druckdünnschicht das Aufbringen einer Druckdünnschicht umfasst, welche eine Dünnschichtspannung von mehr als ungefähr -1400 MPa aufweist.

9. Verfahren nach Anspruch 1, wobei der Schritt des Anordnens einer Zugdünnschicht das Aufbringen einer Zugdünnschicht umfasst, welche eine Dünnschichtspannung von mehr als ungefähr +500 MPa aufweist.

## Revendications

1. Un procédé de fabrication d'une structure d'un dispositif à semi-conducteur, comprenant :
la fourniture d'une région de dispositif p-FinFET (20) et d'une région à dispositif n-FinFET (30) sur un même substrat (1, 2) ;
la disposition d'un premier revêtement (5) sur la région de dispositif p-FinFET et la région de dispositif n-FinFET ;
la disposition d'un film de compression (6) sur le premier revêtement, pour chevaucher les parois latérales longitudinales de l'ailette du p-FinFET ;
la disposition d'un premier masque (7) sur la région de dispositif p-FinFET ;
l'enlèvement du film de compression de la région de dispositif n-FinFET ;
l'enlèvement du premier masque (7) ;
la disposition d'un deuxième revêtement (8) sur la région de dispositif p-FinFET et la région de dispositif n-FinFET ;
la disposition d'un film de traction (9) sur le deuxième revêtement, pour chevaucher les parois latérales longitudinales de l'ailette du n-FinFET ;
la disposition d'un deuxième masque (10) sur la région de dispositif n-FinFET ;
l'enlèvement du film de traction de la région de dispositif p-FinFET ; et
ensuite, l'enlèvement du deuxième masque ;
dans lequel le film de compression et le film de traction sont respectivement déposés pour induire une contrainte de compression et de traction dans la direction longitudinale des FinFETs respectifs.

2. Le procédé tel qu'indiqué à la revendication 1, dans lequel ladite étape de déposition d'un film de compression comprend la déposition d'un film de compression ayant une contrainte de film d'environ -1400 MPa.

3. Le procédé tel qu'indiqué à la revendication 1, dans lequel ladite étape de déposition d'un film de traction comprend la déposition d'un film de traction ayant une contrainte de film d'environ + 500 MPa.

4. Le procédé tel qu'indiqué à la revendication 1, dans lequel le film de compression est du SiN.

5. Le procédé tel qu'indiqué à la revendication 4, dans lequel le film de traction est du SiN.

6. Le procédé tel qu'indiqué à la revendication 1, dans lequel le film de compression est disposé en ayant une épaisseur sensiblement uniforme dans une plage allant de 200Å à 2000Å.

7. Le procédé tel qu'indiqué à la revendication 1, dans lequel le film de traction est disposé en ayant une épaisseur sensiblement uniforme dans une plage allant de 200Å à 2000Å.

8. Le procédé tel qu'indiqué à la revendication 1, dans lequel ladite étape de disposition d'un film de compression comprend la déposition d'un film de compression ayant une contrainte de film supérieure à environ -1400 MPa.

9. Le procédé tel qu'indiqué à la revendication 1, dans lequel ladite étape de disposition d'un film de traction comprend la déposition d'un film de traction ayant une contrainte de film supérieure à environ +500 MPa.
